(19) Europäisches Patentamt

European Patent Office

Office européen des brevets

(11) **EP 1 263 131 A1**

(12) **EUROPEAN PATENT APPLICATION**

(43) Date of publication:
**04.12.2002 Bulletin 2002/49**

(51) Int Cl.7: **H03G 5/00**, H03H 17/02

(21) Application number: **01870110.2**

(22) Date of filing: **28.05.2001**

(84) Designated Contracting States:
**AT BE CH CY DE DK ES FI FR GB GR IE IT LI LU MC NL PT SE TR**
Designated Extension States:
**AL LT LV MK RO SI**

(71) Applicant: **Interuniversitair Micro-Elektronica Centrum 3001 Heverlee (BE)**

(72) Inventors:
• **Debaillie, Björn**
  **B-8434 Westende (BE)**
• **Van Dierdonck, Niek**
  **B-9880 Aalter (BE)**

(74) Representative: **Van Malderen, Joelle et al Office Van Malderen, Place Reine Fabiola 6/1 1083 Bruxelles (BE)**

(54) **Filtering device and method of controlling said device**

(57)    The present invention is related to a method for controlling a filtering device comprising a number of digital peak filters, used to filter a signal according to gains set by a user at a number of center frequencies corresponding to said number of peak filters, characterised in that said method comprises the following steps :

- receiving the desired gains at said number of center frequencies, said gains having been set by said user,

- calculating the peak gains of each sub-filter, so that the overall gain at each center frequency coincides with said desired gains, said calculation being based on out-of-band gain values for a standard peak filter,

- implementing said calculated gains on each of said peak filters.

FIG. 4

**Description**

**Field of the invention**

The present invention is related to a filtering device, in particular a filter bank, which fits a predefined frequency response, for use e.g. in graphic equalisers for hi-fi equipment.

**State of the art**

For reasons such as filter stability and ease of implementation, a filter that has to fit a predefined frequency response is often designed as a bank of lower order subfilters. These subfilters influence each other because a change in one sub-filter affects a frequency range which is larger than the range for which the sub-filter is designed. Thus, the sub-filters are no longer independent. This leads to an inaccurate approximation of the desired frequency response at the specified frequencies, or to an erroneous behaviour of the frequency characteristic in between the specified frequencies.

**Aims of the invention**

The present invention aims to provide a bank of filters wherein the influence of the sub-filters on each other does not deteriorate the overall performance of the filter bank.

**Summary of the invention**

The present invention is related to a method for controlling a filtering device comprising a number of digital peak filters, used to filter a signal according to gains set by a user at a number of center frequencies corresponding to said number of peak filters, characterised in that said method comprises the following steps :

- receiving the desired gains at said number of center frequencies, said gains having been set by said user,
- calculating the peak gains of each sub-filter, so that the overall gain at each center frequency coincides with said desired gains, said calculation being based on out-of-band gain values for a standard peak filter,
- implementing said calculated gains on each of said peak filters.

According to a preferred embodiment of the invention, said calculation is done in iterative steps, so that each calculation step of said peak gains uses the out-of-band gain values corresponding to the peak gains resulting from the previous calculation step.
According to an embodiment of the invention, at a plurality of center frequencies close to the Nyquist frequency, the out-of-band values are chosen from band-specific tables which are valid for non-symmetric frequency response curves.
The method of the invention may further comprise the step of receiving adjusted values of the Q-factors of said peak filters, prior to said steps of receiving desired gain values, calculating peak gain values and implementing said peak gain values, said Q-factors being adjusted by said user.
According to a preferred embodiment of the method of the invention, the Q-factors of peak filters having their center frequencies near the Nyquist frequency are lower than the Q-factors of the other peak filters.
The present invention is equally related to a filtering device controlled by the method according to the invention, comprising :

- a plurality of digital peak filters, said filters having their center frequencies over a given frequency range, the operation of said filters depending on a peak gain and Q-factor as input values,
- means for receiving a number of desired gains at said center frequencies, and a number of values of the Q-factor,
- means for calculating said peak gains, so that the overall gain at each center frequency coincides with said desired gain,

In the filtering device of the invention, said plurality of digital peak filters may form a cascade of peak filters.
In the filtering device of the invention, said plurality of digital peak filters may be implemented on a fixed point DSP or on a floating point DSP.
Said calculating means may be implemented on a floating point DSP. Said calculating means may be implemented on the same floating point DSP as said plurality of peak filters.
When said plurality of digital peak filters is implemented on a fixed point DSP, each peak filter is implemented as a cascade of two identical biquad peak filters.

## Short description of the drawings

Fig. 1 represents a cascade of digital filters.
Fig. 2a represents the structure of a digital peak filter. Fig. 2b represents the frequency response of such a filter.
Fig. 3 represents the frequency response of a cascade of peak filters.
Fig. 4 represents the normalised spectrum of a peak filter.
Fig. 5 illustrates the ripple at high frequencies
Fig. 6 shows the overall frequency response using a filterbank according to the present invention.

## Detailed description of the invention

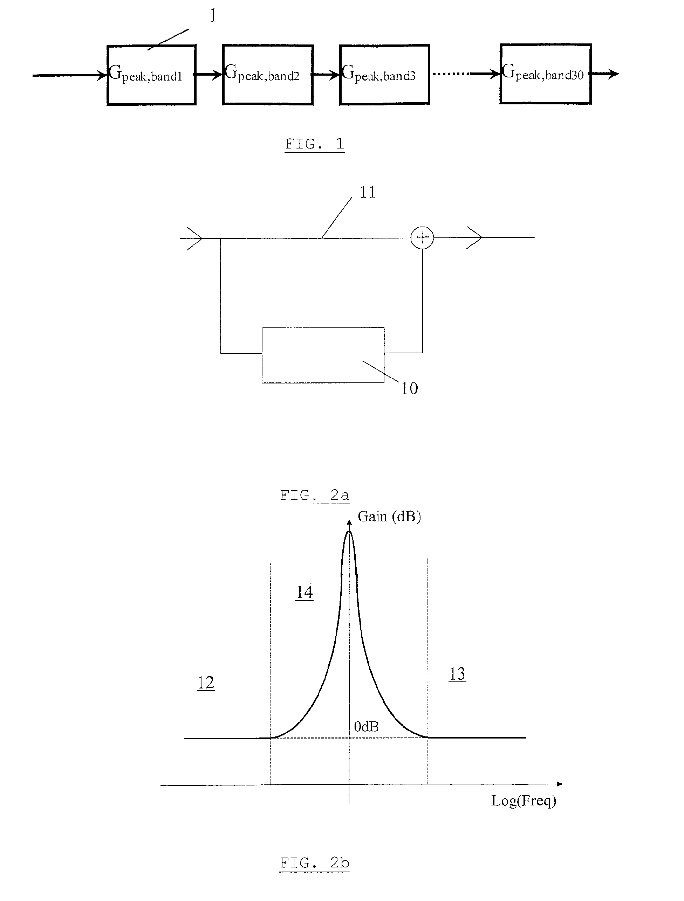

Due to implementation problems in the digital domain, the structure of an analog filter, comprising a set of subfilters in parallel and a feedback loop, cannot be maintained for a digital equalizer. Other structures are therefore preferred, such as a cascade structure, wherein a number of feed forward peak filters 1 are installed, as shown in fig. 1, each peak filter being active in a given frequency band around a center frequency. The desired peak gains at these center frequencies can be adjusted by the user of such a filter structure, for example by way of sliders. In the state of the art, these set values are identical to the peak gain values imposed on each sub-filter in the cascade so that the mutual influence of these sub-filters is ignored. The present invention is related to a method of controlling such a filter structure by first calculating the necessary peak gain to be imposed on each sub-filter in order for the global frequency response function of the filter cascade to reach the desired peak gains at the center frequencies. This calculation, which forms the main characteristic of the invention, is based on the compensation of the mutual influence of the sub-filters. In the following, the specific case of a cascade of digital peak filters is further explained in details, eventhough the scope of the invention is not limited to this type of structure.

The structure of an individual digital peak filter is shown in figure 2a. It consists of a band pass filter 10, combined with a unity throughput 11. The effect is a filter with a frequency response as shown in figure 2b, having unity gain on either side of the center frequency (regions 12, 13), and a gain higher than unity in a region 14 around the center frequency.

The actual frequency response of such a filter depends on two factors : the peak gain at center frequency, and the Q-factor of the band pass filter 10, the latter defining the broadness of the curve. For clarity's sake, whenever reference is made in this text to the 'Q-factor of the peak filter', it should be noted that this actually concerns the Q-factor of the band pass filter which is part of said peak filter.

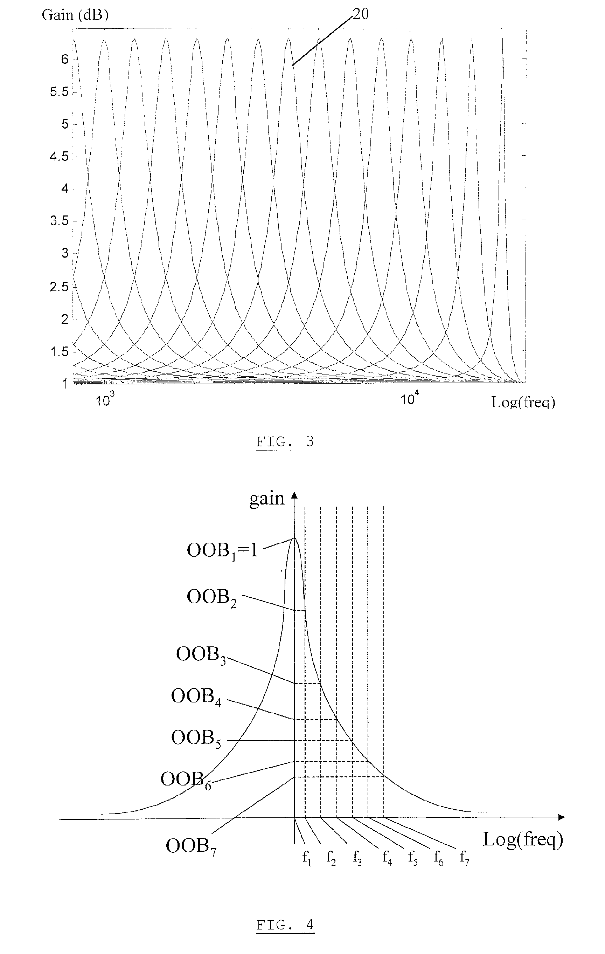

When a number of such digital peak filters are combined in a cascade structure, the resulting frequency response will be the result of the addition of the individual curves 20, see figure 3. Figure 3 shows the common case wherein the center frequencies of a cascade of peak filters are equidistant on a logarithmic frequency scale. The closer the center frequencies are lying together, and the broader the curves are (lower Q) the more mutual influence adjacent curves will exert on each other.

The mutual influence of peak filters whose center frequencies are close to each other is numerically represented by the so called 'Out Of Band' gain : OOB. This is defined as the normalised gain of a given peak filter at a frequency which is essentially outside the filter's center frequency; "normalised" meaning that it is referred to the peak gain of the filter in question, so that OOB equals 1 at the center frequency and less than one on either side of said center frequency.

A distinction needs to be made between the 'set' gain for a given filter band and the gains which need to be implemented on all subfilters in order to acquire in that given band the desired 'set' gain level. The following terminology and notation will be used in this text :

- '$f_i$' = center frequency of peak filter in band number i (i = 1...n).
- '$G_{set,bi}$' = the desired level of the gain, set by the user in frequency band number i.
- '$G_{p,bi}$' = the actual peak gain imposed on the filter for band number i, to acquire a given number of 'set' gains.
- '$OOB_i$' = normalised out-of-band-gain of any peak filter in the frequency band i.
- '$Q_i$' = Q-factor for the filter with center frequency $f_i$.

This is illustrated in figure 4, where the normalised spectrum of the peak filter in band number 1 is shown, along with the center frequencies f2, f3, etc...
In the state of the art, there is no distinction between the set values $G_{set,bi}$ and the values imposed on the filters, $G_{p,bi}$. This means, for n=30 :

$$\begin{cases} G_{set,b1} = G_{p,b1} \\ G_{set,b2} = G_{p,b2} \\ ... \\ G_{set,b30} = G_{p,b30} \end{cases}$$

In other words, prior methods do not take into account the Out of Band values outside the center frequencies.

The present invention proposes a method wherein all the n OOB values are taken into account, so that it is the interaction between the filters at their respective $G_{p,bi}$ values which eventually ensures that the desired set values are reached by the global transfer function.

Supposing in the first instance that the Q-factors $Q_i$ are known and constant values, the method of the invention aims to derive a set of $G_{p,bi}$ values from a given set of $G_{set,bi}$ values.

If one supposes the OOB values to be independent of the filter gain and the center frequency and if one supposes all of the frequency response functions in the frequency range of interest to be symmetrical with respect to the center frequency (as in fig.4), one set of n OOB values needs to be stored, in order to calculate each filter gain $G_{p,bi}$ on the basis of a given set of desired gains $G_{set,bi}$.

For n=30, this is done by solving the following set of linear equations :

$$\begin{cases} G_{set,b1} = OOB_1 \times G_{p,b1} + OOB_2 \times G_{p,b2} + ... + OOB_{30} \times G_{p,b30} \\ G_{set,b2} = OOB_2 \times G_{p,b1} + OOB_1 \times G_{p,b2} + ... + OOB_{29} \times G_{p,b30} \\ ... \\ G_{set,b30} = OOB_{30} \times G_{p,b1} + OOB_{29} \times G_{p,b2} + ... + OOB_1 \times G_{p,b30} \end{cases}$$

However, these OOB values are not independent of the peak filter gain of a given filter. The form of the curve in figure 4 will be different for each value of $G_{p,bi}$, which complicates the problem. In fact, a set of OOB values must be stored for each value of $G_{p,bi}$ (at constant $Q_i$-values) and the corrected set of equations becomes :

$$\begin{cases} G_{set,b1} = OOB_1(G_{p,b1}) \times G_{p,b1} + OOB_2(G_{p,b2}) \times G_{p,b2} + ... + OOB_{30}(G_{p,b30}) \times G_{p,b30} \\ G_{set,b2} = OOB_2(G_{p,b1}) \times G_{p,b1} + OOB_1(G_{p,b2}) \times G_{p,b2} + ... + OOB_{29}(G_{p,b30}) \times G_{p,b30} \\ ... \\ G_{set,b30} = OOB_{30}(G_{p,b1}) \times G_{p,b1} + OOB_{29}(G_{p,b2}) \times G_{p,b2} + ... + OOB_1(G_{p,b30}) \times G_{p,b30} \end{cases}$$

This means that the OOB values become themselves functions of the unknown $G_{p,bi}$ values. Even though these functions are known, the system of equations is no longer linear and therefore cannot be solved in a straightforward way.

The present invention allows to remedy this problem, by using an iterative way of solving the system of equations. The unknown gains $G_{p,bi}$ are then calculated based on the OOB values corresponding to the known $G_{p,bi}$ values a given timespan earlier. This requires another parameter to be regarded, namely the 'old' value of the peak gain at a given moment : $G_{p,biold}$.

The algorithm used in the present invention is then based on the following system of equations :

$$\begin{cases} G_{set,b1} = OOB_1(G_{p,b1old}) \times G_{p,b1} + OOB_2(G_{p,b2old}) \times G_{p,b2} + ... + OOB_{30}(G_{p,b30old}) \times G_{p,b30} \\ G_{set,b2} = OOB_2(G_{p,b1old}) \times G_{p,b1} + OOB_1(G_{p,b2old}) \times G_{p,b2} + ... + OOB_{29}(G_{p,b30old}) \times G_{p,b30} \\ ... \\ G_{set,b30} = OOB_{30}(G_{p,b1old}) \times G_{p,b1} + OOB_{29}(G_{p,b2old}) \times G_{p,b2} + ... + OOB_1(G_{p,b30old}) \times G_{p,b30} \end{cases} \quad (a)$$

As soon as one or more set values are changed, the 'new' values $G_{p,bi}$ are then recalculated from the known 'old' values, at each calculation step. This can be done in a number of fixed gain steps, for example every 0.5dB, until the new gain value is reached, or in a number of iterations starting from the maximum difference between old and new gain value, and recalculating until the new value is reached within an accurate interval.

The solution of the system of equations (a) is still not optimised. The use of the bilinear transformation for calculating the frequency response of each sub-filter causes deformations of these responses, in particular in the high frequency range, i.e. in the bands closest to the Nyquist frequency. In these bands, the curves become asymmetrical and less broad, as illustrated in figure 3.

The asymmetry in the curves is taken into account in the method according to the present invention by so called 'table based compensation', meaning that the OOB values for the higher frequencies, e.g. starting from band 20 in the case of 30 bands, are derived from bandspecific tables, while for the lower frequencies, all OOB values are derived from tables which are valid for one band (e.g. f1).

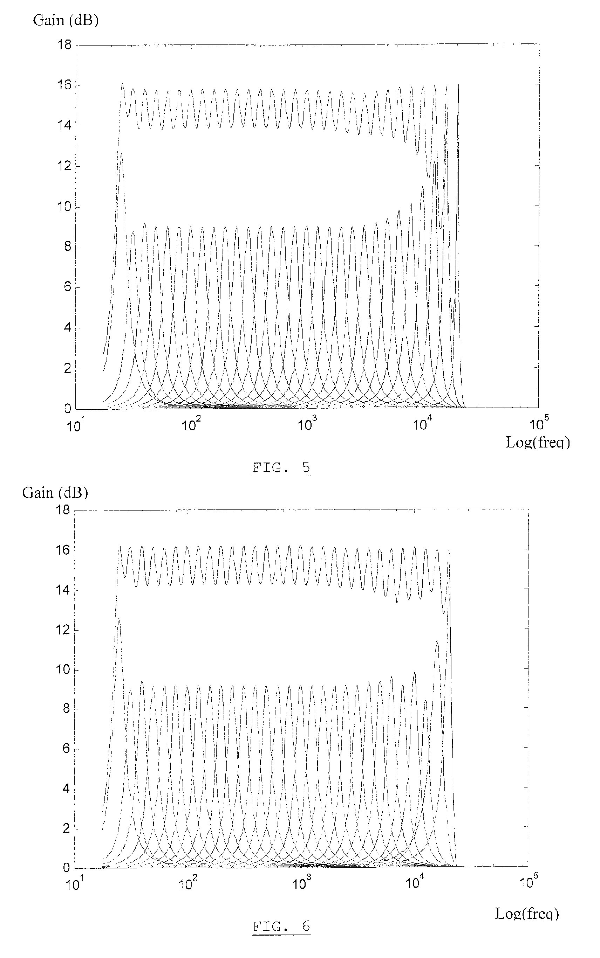

This still leaves the overall gain with problems, as shown in figure 5. The ripple at high frequencies is very important, because the loss in broadness of these high frequency bands has still not been taken into account. This is solved by applying a lower Q-factor for these high frequency bands, which will eventually lead to an overall frequency response as shown in figure 6.

In general, it is the Q-factor which makes sure that no extreme ripple is present between adjacent center frequencies. So far, this parameter has been taken to be a constant throughout the iteration procedure wherein the $G_{p,bi}$ values are calculated. According to one embodiment of the invention, it is then proposed to control the filter cascade by repeatedly solving the system (a) wherein a constant set of Q-values is used , said values being lower in the high frequency range than in the low frequency range.

According to another embodiment of the invention, these Q-factors themselves may be regarded as unknowns, in which case the system (a) would become :

$$\begin{cases} G_{set,b1} = OOB_1(G_{p,b1old},Q_1) \times G_{p,b1} + OOB_2(G_{p,b2old},Q_2) \times G_{p,b2} + ... + OOB_{30}(G_{p,b30old},Q_{30}) \times G_{p,b30} \\ G_{set,b2} = OOB_2(G_{p,b1old},Q_1) \times G_{p,b1} + OOB_1(G_{p,b2old},Q_2) \times G_{p,b2} + ... + OOB_{29}(G_{p,b30old},Q_{30}) \times G_{p,b30} \\ ... \\ G_{set,b30} = OOB_{30}(G_{p,b1old},Q_1) \times G_{p,b1} + OOB_{29}(G_{p,b2old},Q_2) \times G_{p,b2} + ... + OOB_1(G_{p,b30old},Q_{30}) \times G_{p,b30} \end{cases}$$

Solving this system for the unknowns $G_{p,bi}$ and $Q_i$, requires additional equations which would depend on restrictions to be imposed on the ripple between subsequent center frequencies.

A preferred embodiment of the invention works with a set of Q-factors which is constant during adaptation of the peak filters so that system (a) may be used to calculate the $G_{p,bi}$ values. However, the Q-factors may be changed manually, causing a whole new set of OOB values to be calculated and stored for that particular set of Q-factors and for every gain. After the new Q-factors are in place, system (a) will once again be used, but it will be based on the new set of OOB values. In that way, the Q-factors can be used to influence the ripple of the curves, although not during the setting of the gains.

The architecture of a filtering device according to a preferred embodiment of the present invention consists of three layers :

- the implementation layer : this is the 'deepest' layer, comprising a plurality of filter sections in cascade. Each filter section has a gain and a Q-factor as input. The filter coefficients are calculated from this input.
- Calculation layer : this layer calculates the gain and Q-factor which are to be transmitted to the implementation layer. This layer is preferably based on the linear algorithm used to solve the system (a) of equations.

- GUI layer (General User Interface) : this layer permits the interaction with the user;

In practice, this architecture can be realised in a number of ways. According to a first embodiment, the implementation layer is realised on a fixed point DSP. In this case, each filter section is made up of a cascade of two 2nd order biquad peak filters as shown in figure 2a. In this embodiment, the calculation layer is then preferably realised on a floating point DSP.
According to another embodiment, both the implementation layer and the calculation layer are implemented on a floating point DSP. This may be done using two floating point DSP's, one for the implementation layer and one for the calculation layer, or with both layers implemented on one single floating point DSP. When a floating point DSP is used for the implementation layer, one 2nd order biquad filter is used in each filter section.

**Claims**

1. A method for controlling a filtering device comprising a number of digital peak filters (1), used to filter a signal according to gains set by a user at a number of center frequencies corresponding to said number of peak filters, **characterised in that** said method comprises the following steps :

    - receiving the desired gains ($G_{set,bi}$) at said number of center frequencies ($f_i$), said gains having been set by said user,
    - calculating the peak gains ($G_{p,bi}$) of each sub-filter, so that the overall gain at each center frequency coincides with said desired gains, said calculation being based on out-of-band gain values (OOB) for a standard peak filter,
    - implementing said calculated gains on each of said peak filters.

2. A method according to claim 1, wherein said calculation is done in iterative steps, so that each calculation step of said peak gains ($G_{p,bi}$) uses the out-of-band gain values corresponding to the peak gains ($G_{p,biold}$) resulting from the previous calculation step.

3. A method according to claim 1 or 2, wherein at a plurality of center frequencies close to the Nyquist frequency, the out-of-band values are chosen from band-specific tables which are valid for non-symmetric frequency response curves.

4. A method according to any one of the previous claims, further comprising the step of receiving adjusted values of the Q-factors of said peak filters, prior to said steps of receiving desired gain values, calculating peak gain values and implementing said peak gain values, said Q-factors being adjusted by said user.

5. A method according to claim 4 wherein the Q-factors of peak filters having their center frequencies near the Nyquist frequency are lower than the Q-factors of the other peak filters.

6. A filtering device controlled by the method according to any one of claims 1 to 5, comprising :

    - a plurality of digital peak filters, said filters having their center frequencies over a given frequency range, the operation of said filters depending on a peak gain and Q-factor as input values,
    - means for receiving a number of desired gains at said center frequencies, and a number of values of the Q-factor,
    - means for calculating said peak gains, so that the overall gain at each center frequency coincides with said desired gain.

7. A filtering device as described in claim 1, wherein said plurality of digital peak filters form a cascade of peak filters.

8. A filtering device as described in claim 6 or 7, wherein said plurality of digital peak filters is implemented on a fixed point DSP.

9. A filtering device as described in claim 6 or 7, wherein said plurality of digital peak filters is implemented on a floating point DSP.

10. A filtering device as described in any one of claims 6 to 9, wherein said calculating means are implemented on a floating point DSP.

11. A filtering device as described in any one of claim 10, wherein said calculating means are implemented on the same floating point DSP as said plurality of peak filters.

12. A filtering device as described in claim 8, wherein each peak filter is implemented as a cascade of two identical biquad peak filters.

FIG. 1

FIG. 2a

FIG. 2b

FIG. 3

FIG. 4

Gain (dB)

FIG. 5

Gain (dB)

FIG. 6

EP 1 263 131 A1

**European Patent Office**

# EUROPEAN SEARCH REPORT

Application Number

EP 01 87 0110

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 5 687 104 A (BREWER JR PHILLIP K ET AL) 11 November 1997 (1997-11-11) | 1,2 | H03G5/00 H03H17/02 |
| A | * column 2, line 11 - line 52 * * column 4, line 61 - column 10, line 50 * * claims 22-27 * * figures * | 4,6,7 | |
| A | US 5 714 918 A (MENKHOFF ANDREAS) 3 February 1998 (1998-02-03) * column 2, line 21 - line 67 * * column 6, line 23 - line 51 * | 7 | |

| | TECHNICAL FIELDS SEARCHED (Int.Cl.7) |
|---|---|
| | H03G H03H |

The present search report has been drawn up for all claims

| Place of search | Date of completion of the search | Examiner |
|---|---|---|
| THE HAGUE | 17 October 2001 | D/L PINTA BALLE.., L |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 1 263 131 A1**

## ANNEX TO THE EUROPEAN SEARCH REPORT
## ON EUROPEAN PATENT APPLICATION NO.

EP 01 87 0110

This annex lists the patent family members relating to the patent documents cited in the above-mentioned European search report.
The members are as contained in the European Patent Office EDP file on
The European Patent Office is in no way liable for these particulars which are merely given for the purpose of information.

17-10-2001

| Patent document cited in search report | | Publication date | Patent family member(s) | | Publication date |
|---|---|---|---|---|---|
| US 5687104 | A | 11-11-1997 | NONE | | |
| US 5714918 | A | 03-02-1998 | EP | 0758817 A1 | 19-02-1997 |
| | | | DE | 59509450 D1 | 30-08-2001 |
| | | | JP | 9167944 A | 24-06-1997 |

EPO FORM P0459

For more details about this annex : see Official Journal of the European Patent Office, No. 12/82

12